(19) **Europäisches Patentamt / European Patent Office / Office européen des brevets**

(11) **EP 4 468 733 B1**

(12) **FASCICULE DE BREVET EUROPEEN**

(45) Date de publication et mention de la délivrance du brevet:
**20.05.2026 Bulletin 2026/21**

(51) Classification Internationale des Brevets (IPC):
**H04Q 9/04** *(2006.01)* **G01R 31/08** *(2020.01)*
**G01R 31/12** *(2020.01)*

(21) Numéro de dépôt: **24176827.4**

(52) Classification Coopérative des Brevets (CPC):
**H04Q 9/04; G01R 31/08; G01R 31/1272**

(22) Date de dépôt: **20.05.2024**

(54) **SYNCHRONISATION DE DISPOSITIFS D'ACQUISITION DE DONNÉES D'UN SYSTÈME DE SURVEILLANCE EN LIGNE D'UN RÉSEAU DE DISTRIBUTION ÉLECTRIQUE PAR DÉTECTION DE PASSAGES PAR ZÉRO**

SYNCHRONISATION VON DATENERFASSUNGSVORRICHTUNGEN EINES ONLINE-ÜBERWACHUNGSSYSTEMS EINES ELEKTRISCHEN VERTEILUNGSNETZES DURCH NULLDURCHGANGSDETEKTION

SYNCHRONISATION OF DATA ACQUISITION DEVICES OF AN ONLINE MONITORING SYSTEM OF AN ELECTRICAL DISTRIBUTION NETWORK BY DETECTING ZERO CROSSINGS

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **25.05.2023 FR 2305176**

(43) Date de publication de la demande:
**27.11.2024 Bulletin 2024/48**

(73) Titulaire: **Nexans**
**92400 Courbevoie (FR)**

(72) Inventeurs:
- **KAFAL, Moussa**
  **91940 Les Ulis (FR)**
- **GRIOT, Samuel**
  **69007 Lyon (FR)**

(74) Mandataire: **Cabinet Boettcher**
**5, rue de Vienne**
**75008 Paris (FR)**

(56) Documents cités:
**EP-A1- 3 798 649       WO-A1-2015/062628**
**CN-B- 107 085 174**

## Description

### Domaine technique

La présente invention concerne le domaine général de la surveillance du bon fonctionnement des éléments présents dans un réseau de distribution électrique, notamment des câbles électriques, et plus précisément la synchronisation entre au moins deux dispositifs d'acquisition de données appartenant à un système de surveillance en ligne d'un réseau de distribution électrique.

### Arrière-plan technologique

L'un des principaux problèmes susceptibles d'affecter le fonctionnement d'un réseau de transmission et/ou de distribution électrique est l'apparition de décharges partielles sur les câbles, les transformateurs, les appareillages de commutation, les jonctions de câbles, etc. qui peuvent conduire à leur dégradation progressive et, finalement, à des défauts destructeurs.

La détection et la localisation des décharges peuvent fournir des informations cruciales à l'opérateur de réseau concernant l'état de l'isolation des câbles de distribution en fonctionnement et de l'équipement en général.

Des systèmes de surveillance ont déjà été proposés sur la base de mesures à une extrémité d'un câble du réseau, qui utilisent la réflectométrie dans le domaine temporel (TDR) ainsi que des techniques de traitement des signaux. Toutefois, ces systèmes peuvent principalement être utilisés hors ligne et présentent des limites strictes en ce qui concerne leur efficacité et leur champ d'application.

D'autres systèmes connus, appelés systèmes de surveillance en ligne, peuvent détecter et localiser des évènements susceptibles de représenter des anomalies, de type décharge partielle, sans affecter le fonctionnement normal du réseau. Les informations relatives à la progression du phénomène dans le temps peuvent empêcher l'apparition de défauts destructeurs, améliorant ainsi les indices de fiabilité du réseau et évitant que le courant de court-circuit ne sollicite d'autres équipements. En conséquence, de tels systèmes de surveillance en ligne contribuent à l'un des aspects importants du réseau intelligent, à savoir l'utilisation optimale des actifs existants par la mise en œuvre d'une maintenance préventive optimisée et d'une connaissance intelligente de l'état des actifs.

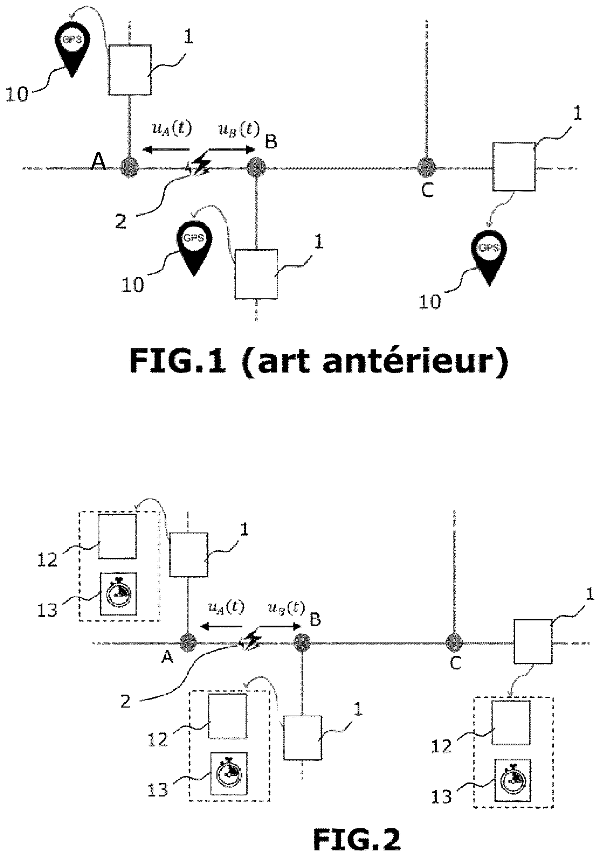

Comme représenté sur la figure 1, qui schématise partiellement un exemple de réseau de distribution électrique maillé, le principe de la surveillance en ligne consiste à placer une pluralité de dispositifs 1 d'acquisition de données en ligne à des emplacements prédéfinis du réseau, par exemple aux extrémités de câbles électriques présents dans ce réseau. Dans l'exemple non limitatif de la figure 1, trois de ces dispositifs 1 d'acquisition de données en ligne ont été représentés placés à trois localisations connues illustrées par les points A, B et C. Les deux dispositifs 1 placés aux points A et B peuvent détecter des évènements correspondant à une décharge partielle survenant à n'importe quelle position d'un câble ou équipement du réseau, par exemple située entre les points A et B ou même en dehors de ces points. De même, les deux dispositifs 1 placés aux points B et C peuvent détecter des évènements correspondant à une décharge partielle survenant à n'importe quelle position d'un câble ou équipement du réseau, par exemple située entre les points B et C, ou même en dehors de ces points.

Le principe connu de la localisation d'une décharge partielle avec ce type de systèmes de surveillance en ligne est le suivant : Si une décharge partielle 2 survient entre les points A et B du réseau, deux signaux impulsionnels correspondant $u_A(t)$ et $u_B(t)$ vont se propager en direction opposée dans le réseau. Le signal $u_A(t)$ est détecté par le dispositif 1 d'acquisition de données situé au point A à un instant $t_{oaA}$, et le signal $u_B(t)$ est détecté par le dispositif 1 d'acquisition de données situé au point B à un instant $t_{oaB}$. La localisation $Z_{PD}$ de la décharge partielle 2 peut ainsi être déterminée selon la relation suivante :

$$Z_{PD} = \frac{t_c - \Delta t_{oa}}{2t_c} \cdot l_c \quad (1)$$

avec

$$\Delta t_{oa} = t_{oa_A} - t_{oa_B} \quad (2)$$

$t_C$, le temps de vol entre les points A et B; et
$l_c$ la longueur connue de câble séparant les points A et B.

Afin de pouvoir déterminer la quantité $\Delta t_{oa}$, et par suite, la localisation $Z_{PD}$, il est donc nécessaire de synchroniser les deux dispositifs 1 d'acquisition de données situés aux points A et B. En d'autres termes, les instants d'arrivée $t_{oaA}$ et $t_{oaB}$ des signaux $u_A(t)$ et $u_B(t)$ acquis par chacun des deux dispositifs 1 d'acquisition de données doivent être déterminés dans un référentiel temporel commun.

Comme visible sur la figure 1, il est déjà connu d'associer chaque dispositif 1 d'acquisition de données du système de surveillance à un récepteur 10 d'un système de navigation par satellite, par exemple un récepteur GPS 10. Chaque évènement détecté par chacun des dispositifs 1 d'acquisition de données, par exemple le signal précédent $u_A(t)$ ou $u_B(t)$ généré par une décharge partielle, peut ainsi être horodaté dans un système de référence commun. Cette méthode de synchronisation est décrite par exemple dans le document WO 2021/138569. La différence entre les temps d'arrivée des signaux $u_A(t)$ et $u_B(t)$ au niveau des deux dispositifs 1 d'acquisition de données, exprimés dans une référence de temps commune, et par suite, la localisation $Z_{PD}$ de la décharge partielle, peuvent ensuite être déterminées par application des relations (1) et (2) cidessus.

Néanmoins, bien que la précision du GPS puisse être très élevée, plusieurs facteurs peuvent introduire des erreurs, tels que les effets de la propagation multiple du signal GPS, les erreurs de localisation des satellites, les conditions atmosphériques et, surtout, les difficultés d'installation. En effet, l'utilisation correcte des systèmes GPS implique l'utilisation d'antennes qui doivent être installées en espace libre pour permettre de capter le signal du satellite. Or, outre le fait que ces antennes sont coûteuses, de nombreux réseaux de distribution électrique haute tension ou moyenne tension sont des réseaux de distribution souterrains pour lesquels on souhaite minimiser les besoins d'installer des équipements en surface.

Une autre méthode connue, décrite dans le document WO 2004/013642 A2, consiste à injecter des impulsions de synchronisation haute fréquence à l'une des extrémités d'un câble sous surveillance d'un réseau de distribution, à l'aide d'un coupleur inductif. Les données acquises par les systèmes de surveillance utilisés aux deux extrémités du câble, générées par des impulsions de décharge partielle dans le câble contiennent ainsi à la fois des impulsions de décharge partielles et des impulsions de synchronisation. En alignant les ensembles de données et en utilisant le délai entre l'impulsion de décharge partielle et l'impulsion de synchronisation, il est possible d'obtenir l'emplacement de la décharge partielle. Cette méthode de synchronisation temporelle utilise le câble d'alimentation comme support de transmission des impulsions de synchronisation, ce qui atténue l'inconvénient de l'invisibilité des satellites et les problèmes de conditions atmosphériques associés au GPS. Cependant, la précision de cette méthode est fortement affectée par l'atténuation et la dispersion des impulsions de synchronisation se propageant dans le câble. Il en résulte une perte des données temporelles envoyées par le câble.

**Résumé de l'invention**

La présente invention a pour but de pallier les inconvénients des méthodes et systèmes pour synchroniser au moins deux dispositifs d'acquisition de données d'un système de surveillance en ligne d'un réseau de distribution électrique.

Plus précisément, la présente invention a pour objet un procédé de synchronisation entre au moins un premier dispositif et un deuxième dispositif d'acquisition de données d'un système de surveillance en ligne d'un réseau de distribution électrique, chaque dispositif d'acquisition de données étant localisé en un point connu du réseau et étant configuré pour détecter des évènements haute fréquence lors de phases d'acquisition de données, le procédé comportant :

une première phase d'estimations de la période du signal électrique parcourant le réseau consistant à :

- prélever le signal électrique parcourant le réseau au niveau du premier dispositif d'acquisition de données et en déduire une première estimation $T'_A$ de la période du signal électrique par détection des instants de passages par zéro du signal prélevé, horodatés localement par un premier moyen d'horodatage associé au premier dispositif d'acquisition de données ;
- prélever le signal électrique parcourant le réseau au niveau du deuxième dispositif d'acquisition de données et en déduire une deuxième estimation $T'_B$ de la période du signal électrique par détection des instants de passages par zéro du signal prélevé, horodatés localement par un deuxième moyen d'horodatage associé au deuxième dispositif d'acquisition de données ;

suivie d'une deuxième phase de synchronisation comprenant les étapes suivantes :

- envoi par le premier dispositif d'acquisition de données d'un signal d'information à un premier instant de détection $t_{ZCA1,1}$, horodaté localement, d'un nouveau passage à zéro du signal prélevé au niveau du premier dispositif d'acquisition de données ;
- horodatage local de l'instant de réception dudit signal d'information par le deuxième dispositif d'acquisition de données ;

- déclenchement, par le premier dispositif d'acquisition de données, d'une première phase d'acquisition d'évènements haute fréquence sur une pluralité de cycles successifs de durée de cycle prédéfinie, la première phase d'acquisition étant déclenchée à un premier instant de déclenchement $t_{RA}$ déterminé localement par le premier moyen d'horodatage et séparé du premier instant de détection d'une durée correspondant à la première estimation $T'_A$ de la période du signal électrique ;
- après écoulement d'une durée correspondant à la moitié de la deuxième estimation $T'_B$ de la période du signal électrique suivant ledit instant de réception, déclenchement, par le deuxième dispositif d'acquisition de données, d'une deuxième phase d'acquisition d'évènements haute fréquence sur une pluralité de cycles successifs de durée de cycle prédéfinie, la deuxième phase d'acquisition étant déclenchée à un deuxième instant de déclenchement $t_{RB}$ déterminé localement par le deuxième moyen d'horodatage et correspondant à un deuxième instant de détection d'un nouveau passage à zéro du signal prélevé au niveau du deuxième dispositif d'acquisition de données ; et
- détermination d'une différence de synchronisation $\Delta t_{oa}$ entre un premier évènement haute fréquence et un deuxième évènement haute fréquence acquis, sur un cycle donné, respectivement par le premier dispositif d'acquisition de données à un premier instant d'acquisition horodaté localement par le premier moyen d'horodatage et par le deuxième dispositif d'acquisition de données à un deuxième instant d'acquisition horodaté localement par le deuxième moyen d'horodatage par calcul de la différence entre le deuxième instant de déclenchement $t_{RB}$ et le premier instant de déclenchement $t_{RA}$.

Dans un mode de réalisation possible, la durée de cycle prédéfinie pour chaque cycle de la première phase d'acquisition de données correspond à la première estimation $T'_A$ de la période du signal électrique, et la durée de cycle prédéfinie pour chaque cycle de la deuxième phase d'acquisition de données correspond à la deuxième estimation $T'_B$ de la période du signal électrique.

Dans un mode de réalisation possible, les cycles successifs dans la première phase et la deuxième phase d'acquisition de données sont consécutifs.

En variante, les cycles successifs dans la première phase et la deuxième phase d'acquisition de données sont séparés deux à deux d'une durée d'espacement Ts prédéfinie correspondant à un nombre prédéfini de passages consécutifs par zéro.

Dans un mode de réalisation possible, le premier évènement haute fréquence détecté par le premier dispositif d'acquisition de données et le deuxième évènement haute fréquence détecté par le deuxième dispositif de données sur un cycle donné correspondent à deux signaux générés par une même décharge partielle en un point du réseau situé entre le premier et le deuxième dispositifs d'acquisition de données, et le procédé comporte en outre une étape de calcul de la localisation $Z_{PD}$ de la décharge partielle selon la relation

$$Z_{PD} = \frac{TOF' - \Delta t_{oa}}{2TOF'} \cdot l_c$$

dans laquelle $l_c$ est une longueur de câble entre le premier et le deuxième dispositifs d'acquisition de données. Notamment, TOF' désigne le temps de vol entre le point A et le point B. Notamment, en particulier dans la relation cidessus, $\Delta t_{oa}$ désigne la différence entre l'instant d'arrivée de la décharge partielle au point A horodaté localement par le premier moyen d'horodatage et l'instant d'arrivée de la décharge partielle au point B horodaté localement par le deuxième moyen d'horodatage, corrigée avec la différence entre le deuxième instant de déclenchement $t_{RB}$ et le premier instant de déclenchement $t_{RA}$.

La présente invention a également pour objet un système de surveillance en ligne d'un réseau de distribution électrique comportant au moins un premier et un deuxième dispositif d'acquisition de données, chaque dispositif d'acquisition de données étant localisé en un point connu du réseau et étant configuré pour détecter des évènements haute fréquence lors de phases d'acquisition de données, le système de surveillance en ligne étant caractérisé en ce qu'il comporte :

- un premier moyen d'horodatage local et un premier module de détection de passage par zéro, associés au premier dispositif d'acquisition de données, et configurés pour prélever le signal électrique parcourant le réseau au niveau du premier dispositif d'acquisition de données et détecter les instants de passages par zéro du signal prélevé, horodatés localement par le premier moyen d'horodatage ;
- un deuxième moyen d'horodatage local et un deuxième module de détection de passages par zéro, associés au deuxième dispositif d'acquisition de données, et configurés pour prélever le signal électrique parcourant le réseau au niveau du deuxième dispositif d'acquisition de données et détecter les instants de passages par zéro du signal prélevé, horodatés localement par le deuxième moyen d'horodatage ; et

- des moyens de synchronisation configurés pour :

lors d'une première phase d'estimations, déduire une première estimation $T'_A$ de la période du signal électrique à partir d'instants de passages par zéro successivement horodatés localement par le premier moyen d'horodatage, et
une deuxième estimation $T'_B$ de la période du signal électrique à partir d'instants de passages par zéro successivement horodatés localement par le deuxième moyen d'horodatage,
et pour effectuer une deuxième phase de synchronisation comprenant les étapes suivantes :

- envoi par le premier dispositif d'acquisition de données d'un signal d'information à un premier instant de détection $t_{ZCA1,1}$, horodaté localement, d'un nouveau passage à zéro du signal prélevé au niveau du premier dispositif d'acquisition de données ;
- horodatage local de l'instant de réception dudit signal d'information par le deuxième dispositif d'acquisition de données ;
- déclenchement, par le premier dispositif d'acquisition de données, d'une première phase d'acquisition d'évènements haute fréquence sur une pluralité de cycles successifs de durée de cycle prédéfinie, la première phase d'acquisition étant déclenchée à un premier instant de déclenchement $t_{RA}$ déterminé localement par le premier moyen d'horodatage et séparé du premier instant de détection d'une durée correspondant à la première estimation $T'_A$ de la période du signal électrique ;
- après écoulement d'une durée correspondant à la moitié de la deuxième estimation $T'_B$ de la période du signal électrique suivant ledit instant de réception, déclenchement, par le deuxième dispositif d'acquisition de données, d'une deuxième phase d'acquisition d'évènements haute fréquence sur une pluralité de cycles successifs de durée de cycle prédéfinie, la deuxième phase d'acquisition étant déclenchée à un deuxième instant de déclenchement $t_{RB}$ déterminé localement par le deuxième moyen d'horodatage et correspondant à un deuxième instant de détection d'un nouveau passage à zéro du signal prélevé au niveau du deuxième dispositif d'acquisition de données ; et
- détermination d'une différence de synchronisation $\Delta t_{oa}$ entre un premier évènement haute fréquence et un deuxième évènement haute fréquence acquis, sur un cycle donné, respectivement par le premier dispositif d'acquisition de données à un premier instant d'acquisition horodaté localement par le premier moyen d'horodatage et par le deuxième dispositif d'acquisition de données à un deuxième instant d'acquisition horodaté localement par le deuxième moyen d'horodatage par calcul de la différence entre le deuxième instant de déclenchement $t_{RB}$ et le premier instant de déclenchement $t_{RA}$.

Dans un mode de réalisation possible, le premier moyen d'horodatage et le deuxième moyen d'horodatage sont des compteurs N bits, N étant un entier supérieur ou égal à 16.

Dans un mode de réalisation possible, le premier moyen d'horodatage est intégré au premier dispositif d'acquisition des données, et/ou le deuxième moyen d'horodatage est intégré au deuxième dispositif d'acquisition des données.

Dans un mode de réalisation possible, le premier module de détection de passage par zéro est intégré au premier dispositif d'acquisition des données, et/ou le deuxième module de détection de passage par zéro est intégré au deuxième dispositif d'acquisition des données.

**Brève description des figures**

La description qui va suivre en regard des dessins annexés, donnés à titre d'exemples non limitatifs, fera bien comprendre en quoi consiste l'invention et comment elle peut être réalisée. Sur les figures annexées :

la figure 1, déjà décrite ci-avant, illustre partiellement et schématiquement un exemple de réseau de distribution électrique avec un système de surveillance en ligne comprenant des dispositifs d'acquisition de données synchronisés de manière connue sur la base d'un système de navigation de type GPS;
la figure 2 illustre partiellement et schématiquement un exemple de un réseau de distribution électrique avec des dispositifs d'acquisition de données synchronisés selon un mode de réalisation possible de l'invention;
la figure 3 illustre schématiquement un dispositif d'acquisition de données conforme à un mode de réalisation possible selon l'invention;
la figure 4 illustre des étapes possibles pour un procédé de synchronisation conforme à l'invention ;
la figure 5 illustre schématiquement certaines étapes du procédé de la figure 4 ;
la figure 6 illustre schématiquement d'autres étapes du procédé de la figure 4.

**Description de mode(s) de réalisation**

Dans les figures, les éléments identiques ou équivalents porteront les mêmes signes de référence. Les différents schémas ne sont pas à l'échelle.

Dans la suite, la synchronisation entre au moins deux dispositifs d'acquisition de données d'un système de surveillance selon l'invention sera décrite dans le cas non limitatif où le système de surveillance en ligne est configuré pour identifier et localiser des décharges partielles dans le réseau. Le principe de synchronisation peut néanmoins être élargi à tout système de surveillance en ligne disposant de plusieurs dispositifs d'acquisition de données qui doivent être synchronisés.

La figure 2 illustre partiellement un réseau de distribution électrique similaire au réseau de la figure 1, comprenant un système de surveillance d'évènements. Le réseau de distribution électrique est par exemple un réseau haute tension ou moyenne tension, composé d'une pluralité de câbles électriques, d'accessoires de connexion ou de raccordement, d'appareillages et/ou de transformateurs. Le système comprend une pluralité de dispositifs 1 d'acquisition placés en différents points connus du réseau, tels que les points A, B et C représentés sur la figure 2. Les points A, B, C où sont localisés les dispositifs d'acquisition de données sont de préférence situés aux extrémités de câbles ou de tronçons de câbles. Dans le cas non limitatif d'un réseau souterrain, les dispositifs 1 d'acquisition de données sont placés de préférence à des endroits faciles d'accès, par exemple au niveau des transformateurs.

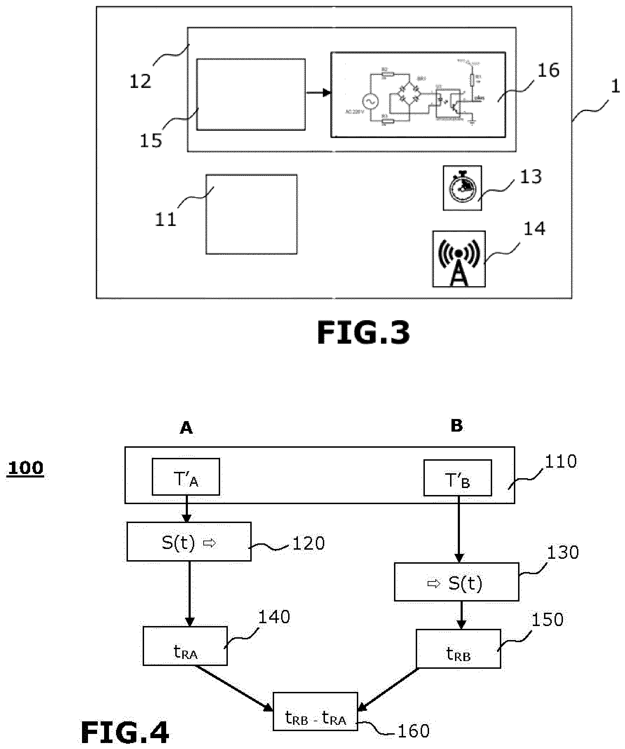

Les dispositifs 1 étant ici dédiés, de façon non limitative, à la détection et la localisation des décharges partielles, chaque dispositif 1 comporte classiquement, comme illustré schématiquement sur la figure 3, des moyens de détection 11 aptes à détecter des évènements impulsionnels occasionnés dans les câbles par les décharges partielles, tels que les impulsions haute fréquence $u_A(t)$ et $u_B(t)$ engendrées par la décharge impulsionnelle 2 de la figure 2. Les moyens 11 sont par exemple un capteur non invasif, de préférence un capteur inductif 11, situé autour du câble au point de localisation du dispositif. En lieu et place du récepteur GPS 10 de la figure 1, le système de surveillance en ligne comporte en outre :

- un premier moyen d'horodatage local 13 et un premier module de détection de passage par zéro 12, associés au premier dispositif 1 d'acquisition de données, et configurés pour prélever le signal électrique parcourant le réseau au niveau du premier dispositif d'acquisition de données 1 et détecter les instants de passages par zéro du signal prélevé, horodatés localement par le premier moyen d'horodatage 13 ;
- un deuxième moyen d'horodatage local 13 et un deuxième module de détection de passages par zéro 12, associés au deuxième dispositif 1 d'acquisition de données, et configurés pour prélever le signal électrique parcourant le réseau au niveau du deuxième dispositif d'acquisition de données 1 et détecter les instants de passages par zéro du signal prélevé, horodatés localement par le deuxième moyen d'horodatage 13.

Par « associé », on entend que chaque moyen d'horodatage local 13 et/ou chaque module de détection de passages par zéro 12 est soit relié électriquement et fonctionnellement à chaque dispositif 1, soit intégré dans chaque dispositif 1, comme illustré sur la figure 3.

Chaque dispositif 1 d'acquisition de données peut comporter en outre avantageusement un module 14 de communication mobile (4G ou plus) ou par Ethernet, lui permettant notamment de recevoir voir des signaux de contrôle émis par un serveur distant (non représenté) compris dans le système de surveillance en ligne, ou de transmettre des informations, telles que les données acquises, à ce serveur ou à tout autre dispositif 1 du système de surveillance. Chaque dispositif 1 est également apte à émettre des signaux d'information à destination de tout autre dispositif 1 compris dans le système de surveillance, ou à recevoir de tels signaux d'information. Ces signaux d'information peuvent être transmis via les moyens de détection 11, utilisés dans un mode actif, le signal d'information étant alors injecté dans le réseau, en particulier dans le câble au point de localisation du dispositif 1, et récupéré via les moyens de détection d'un autre dispositif 1. En variante, les signaux d'information peuvent être émis/reçus par l'intermédiaire des modules 14 de communication mobile (ou par Ethernet compris dans chaque dispositif 1.

Chaque moyen d'horodatage local 13 est de préférence une horloge locale précise, ou un compteur de 16 bits ou plus. Un tel moyen d'horodatage local 13 permet d'horodater localement tout ce qui se passe au niveau de chaque dispositif 1, notamment les détections de passage par zéro, l'émission ou la réception de tout signal d'information, et chaque évènement détecté par le capteur haute fréquence 11 au point de localisation du dispositif 1 d'acquisition de données, lors d'une phase d'acquisition de données.

Chaque module de détection de passage par zéro 12 comporte un capteur basse fréquence 15 apte à prélever le signal sinusoïdal électrique parcourant le réseau à la fréquence fondamentale de 50 Hz ou 60 Hz selon les pays au point de localisation (A, B ou C) du dispositif 1 considéré, et un circuit de détection de passages par zéro 16 recevant le signal prélevé par le capteur basse fréquence 15. Le capteur basse fréquence 15 est de préférence un capteur non invasif, par exemple un magnétomètre ELF sans contact ou un capteur ELF inductive (ELF étant les initiales anglo-saxonne mises pour « Extremely Low Frequency »). Des capteurs capacitifs basse fréquence peuvent néanmoins être envisagés. Le circuit 16 peut implémenter n'importe quel algorithme connu de détection de passage par zéro. Le circuit détecteur de passages par zéro 16 peut être tout circuit comparateur connu permettant de détecter la tension du signal prélevé lorsqu'elle passe du niveau positif au niveau négatif et du niveau négatif au niveau positif.

Le système de surveillance en ligne comporte enfin également des moyens de synchronisation temporelle configurés pour implémenter les étapes d'un procédé de synchronisation conforme à l'invention, qui va à présent être explicité.

Le procédé de synchronisation utilisé par les dispositifs 1 d'acquisition de données, conformément à la présente invention, est illustré sur la figure 4. Par souci de simplification, l'explication est faite en ce qui concerne les deux dispositifs 1 localisés aux points A et B, mais peut aisément être étendue à tous les dispositifs 1 d'acquisition de données présents dans le réseau électrique :

Le procédé de synchronisation 100 débute par une phase d'estimations de la période du signal électrique transitant dans le réseau, faite au niveau de chaque dispositif 1 d'acquisition de données, et notamment au niveau de chaque module de détection de passages par zéro 12. Plus précisément, la phase d'estimation 110 consiste à :

- d'une part, prélever le signal électrique parcourant le réseau au niveau du premier dispositif 1 d'acquisition de données, localisé au point A, et en déduire une première estimation $T'_A$ de la période du signal électrique par détection des instants de passages par zéro du signal prélevé, horodatés localement par un premier moyen d'horodatage 13 associé au premier dispositif 1 d'acquisition de données ;
- d'autre part, prélever le signal électrique parcourant le réseau au niveau du deuxième dispositif 1 d'acquisition de données, localisé au point B, et en déduire une deuxième estimation $T'_B$ de la période du signal électrique par détection des instants de passages par zéro du signal prélevé, horodatés localement par un deuxième moyen d'horodatage 13 associé au deuxième dispositif d'acquisition de données.

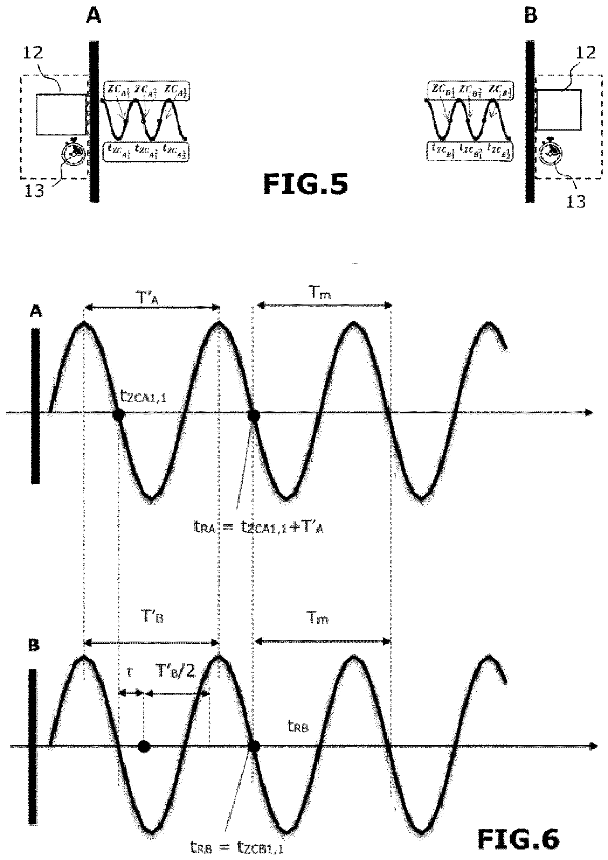

Comme illustré schématiquement sur la figure 5, et compte-tenu du fait que le signal prélevé correspond au signal électrique sinusoïdal à la fréquence fondamentale du réseau électrique (i.e. à 50 Hz ou 60 Hz selon les pays), ce signal passe deux fois par zéro lors de chaque période de signal. Autrement dit, chaque module de détection de passages à zéro va pouvoir détecter une paire de passages à zéro pour chaque période du signal périodique prélevé au niveau du dispositif 1 localisé au point A, respectivement du signal périodique prélevé au niveau du dispositif 1 localisé au point B. Chaque dispositif va également pouvoir horodater localement chaque détection de passage à zéro via son moyen d'horodatage 13. Si l'on note :

$$\left\{\left(ZC_{A_1^1}, ZC_{A_1^2}\right), \left(ZC_{A_2^1}, ZC_{A_2^2}\right), \ldots, \left(ZC_{A_M^1}, ZC_{A_M^2}\right)\right\},$$

respectivement $\left\{\left(ZC_{B_1^1}, ZC_{B_1^2}\right), \left(ZC_{B_2^1}, ZC_{B_2^2}\right), \ldots, \left(ZC_{B_M^1}, ZC_{B_M^2}\right)\right\}$

M paires successives de passages à zéro détectés par le dispositif 1 localisé au point A, respectivement au point B, et

$$\left\{\left(t_{ZC_{A_1^1}}, t_{ZC_{A_1^2}}\right), \left(t_{ZC_{A_2^1}}, t_{ZC_{A_2^2}}\right), \ldots, \left(t_{ZC_{A_M^1}}, t_{ZC_{A_M^2}}\right)\right\},$$

respectivement $\left\{\left(t_{ZC_{B_1^1}}, t_{ZC_{B_1^2}}\right), \left(t_{ZC_{B_2^1}}, t_{ZC_{B_2^2}}\right), \ldots, \left(t_{ZC_{B_M^1}}, t_{ZC_{B_M^2}}\right)\right\}$

les paires d'instants associés obtenus par horodatage local via le moyen d'horodatage 13 associé au dispositif 1 d'acquisition de données localisé au point A, respectivement au point B, l'estimation $T'_A$, respectivement $T'_B$, de la période du signal périodique est calculée selon la relation :

$$T'_A = 2 \times \sum_{i=1}^{M} \left(t_{ZC_{A_i^2}} - t_{ZC_{A_i^1}}\right)$$

respectivement $T'_B = 2 \times \sum_{i=1}^{M} \left(t_{ZC_{B_i^2}} - t_{ZC_{B_i^1}}\right)$

Plus l'entier M est grand, plus on s'affranchit des fluctuations qui pourraient affecter le signal périodique en raison de surcharge ou de la présence d'équipements dans le réseau. L'entier M peut être par exemple égal à 100, voire 200 ou 300.

Une fois que chaque dispositif a pu estimer localement la période $T'_A$ ou $T'_B$ du signal périodique prélevé, le procédé 100 se poursuit par une deuxième phase de synchronisation comprenant les étapes suivantes (voir conjointement les figures 4 et 6) :

Le dispositif 1 d'acquisition de données localisé au point A envoie, lors d'une étape 120, un signal d'information s(t) à un premier instant de détection $t_{ZCA1,1}$, horodaté localement, d'un nouveau passage à zéro du signal prélevé au niveau de ce dispositif 1 d'acquisition de données. Comme vu précédemment, ce signal s(t) peut être envoyé par tout canal de transmission (par le réseau luimême en injectant le signal dans le câble ou par une communication cellulaire ou par Ethernet. Le signal s(t) peut être de tout type.

Lors d'une étape 130, le signal d'information s(t) est reçu par le dispositif 1 d'acquisition de données localisé au point B, au bout d'une durée correspondant au temps de vol $\tau$ entre les deux points A et B. A noter que ce temps de vol T est généralement de l'ordre de la microseconde pour une distance maximum d'environ 15 km séparant les deux points A et B. Lors de cette étape 130, l'instant de réception de ce signal d'information s(t) est horodaté localement par le moyen d d'horodatage local 13 associé à ce dispositif 1.

Lors d'une étape 140, le dispositif 1 d'acquisition de données déclenchement localisé au point A déclenche une première phase d'acquisition d'évènements haute fréquence par son capteur 11, sur une pluralité de cycles successifs de durée de cycle prédéfinie $T_m$, la première phase d'acquisition étant déclenchée à un premier instant de déclenchement $t_{RA}$ déterminé localement par le premier moyen d'horodatage local 13 et séparé du premier instant de détection $t_{ZCA1,1}$ d'une durée correspondant à la première estimation $T'_A$ de la période du signal électrique.

Par ailleurs, après écoulement d'une durée correspondant à $T'_B/2$ suivant l'instant de réception du signal s(t), le dispositif 1 d'acquisition de données localisé au point B déclenche, lors d'une étape 150, une deuxième phase d'acquisition d'évènements haute fréquence par son propre capteur 11, sur une pluralité de cycles successifs de durée de cycle prédéfinie, la deuxième phase d'acquisition étant déclenchée à un deuxième instant de déclenchement $t_{RB}$ déterminé localement par le deuxième moyen d'horodatage 13 et correspondant à un deuxième instant de détection d'un nouveau passage à zéro du signal prélevé au niveau du deuxième dispositif 1 d'acquisition de données.

Dans un mode de réalisation particulièrement avantageux, la durée de cycle prédéfinie pour chaque cycle de la première phase d'acquisition de données correspond à la première estimation $T'_A$ de la période du signal électrique, et la durée de cycle prédéfinie pour chaque cycle de la deuxième phase d'acquisition de données correspond à la deuxième estimation $T'_B$ de la période du signal électrique. En conséquence, les durées de cycles pour les deux phases se correspondent.

Comme le montre la figure 6, les instants de déclenchement $T_{RA}$ et $T_{RB}$, bien que mesurés localement par chaque moyen d'horodatage 13, sont censés coïncider dans un référentiel temporel commun.

Il en résulte qu'il est possible de déterminer, lors d'une étape 160, détermination, une différence de synchronisation $\Delta t_{oa}$ entre un premier évènement haute fréquence et un deuxième évènement haute fréquence acquis, sur un cycle donné, respectivement par le dispositif 1 d'acquisition de données localisé au point A, à un premier instant d'acquisition horodaté localement par son propre moyen d'horodatage 13, et par le deuxième dispositif d'acquisition de données 1 localisé au point B, à un deuxième instant d'acquisition horodaté localement par son propre moyen d'horodatage 13 par simple calcul de la différence entre le deuxième instant de déclenchement $t_{RB}$ et le premier instant de déclenchement $t_{RA}$. Ce calcul peut être effectué en local (par exemple au niveau du premier dispositif 1 localisé au point A) ou centralisé au niveau du serveur distant.

Dans un mode de réalisation possible, les cycles successifs dans la première phase et la deuxième phase d'acquisition de données sont séparés deux à deux d'une durée d'espacement Ts prédéfinie correspondant à un nombre prédéfini de passages consécutifs par zéro.

En variante, les cycles successifs dans la première phase et la deuxième phase d'acquisition de données sont consécutifs, ce qui revient à dire que la durée d'espacement Ts est nulle.

Dans tous les cas, un cycle (n+1) pour le dispositif 1 localisé au point A, respectivement au point B, débute à un instant $t_{RA_{n+1}}$, respectivement $t_{RB_{n+1}}$, qui peut s'exprimer en fonction du cycle n précédent, selon la relation :

$$t_{RA_{n+1}} = t_{oa_{A_n}} + T_m + T_s,$$

respectivement $t_{RB_{n+1}} = t_{oa_{B_n}} + T_m + T_s$ de sorte que, pour chaque cycle n, on conserve la relation

$$\Delta t_{oa_n} = t_{oa_{B_n}} - t_{oa_{A_n}} = t_{RB_{n+1}} - t_{RA_{n+1}}$$

Tout évènement haute fréquence susceptible d'être détecté par les moyens de détection 11 du dispositif 1 localisé au point A ou du dispositif 1 localisé au point B lors de phases d'acquisition de données vont par suite pouvoir être horodatés d'abord localement, via les moyens d'horodatage locaux 13, puis dans une base de référence commune grâce à la connaissance de la différence de synchronisation $\Delta t_{oa}$ entre les deux dispositifs 1 d'acquisition de données.

Dans le cas non limitatif où les dispositifs 1 d'acquisition de données sont dédiés à la détection d'évènements haute fréquence correspondants à des signaux $u_A(t)$ et $u_B(t)$ générés par une même décharge partielle 2, le procédé comporte en outre une étape (non représentée) de calcul de la localisation $Z_{PD}$ de la décharge partielle selon la relation

$$Z_{PD} = \frac{TOF' - \Delta t_{oa}}{2TOF'} . l_C$$

dans laquelle $l_C$ est une longueur de câble entre le premier et le deuxième dispositifs (1) d'acquisition de données. Notamment, TOF' désigne le temps de vol entre le point A et le point B. Notamment, en particulier dans la relation ci-dessus, $\Delta t_{oa}$ désigne la différence entre l'instant d'arrivée de la décharge partielle au point A horodaté localement par le premier moyen d'horodatage et l'instant d'arrivée de la décharge partielle au point B horodaté localement par le deuxième moyen d'horodatage, corrigée avec la différence entre le deuxième instant de déclenchement $t_{RB}$ et le premier instant de déclenchement $t_{RA}$. En particulier, cela ressort du passage en paragraphe [0007] et du passage en paragraphe [00042].

Cette étape de calcul peut par exemple être réalisée au niveau du serveur central distant.

Les étapes 110 à 160 sont de préférence répétées périodiquement (par exemple une ou plusieurs fois par jour) de manière à compenser les dérives pouvant affecter le réseau, telles que des changements de températures, des surcharges, et/ou une dispersion dans les compteurs 13).

## Revendications

1.  Procédé de synchronisation entre au moins un premier dispositif (1) et un deuxième dispositif (1) d'acquisition de données d'un système de surveillance en ligne d'un réseau de distribution électrique, chaque dispositif (1) d'acquisition de données étant localisé en un point connu du réseau et étant configuré pour détecter des évènements haute fréquence lors de phases d'acquisition de données, le procédé comportant :

    une première phase (110) d'estimations de la période du signal électrique parcourant le réseau consistant à :

    - prélever le signal électrique parcourant le réseau au niveau du premier dispositif (1) d'acquisition de données et en déduire une première estimation $T'_A$ de la période du signal électrique par détection des instants de passages par zéro du signal prélevé, horodatés localement par un premier moyen d'horodatage (13) associé au premier dispositif (1) d'acquisition de données ;
    - prélever le signal électrique parcourant le réseau au niveau du deuxième dispositif (1) d'acquisition de données et en déduire une deuxième estimation $T'_B$ de la période du signal électrique par détection des instants de passages par zéro du signal prélevé, horodatés localement par un deuxième moyen d'horodatage (13) associé au deuxième dispositif d'acquisition de données ;

    suivie d'une deuxième phase de synchronisation comprenant les étapes suivantes :

    - envoi (120) par le premier dispositif d'acquisition de données d'un signal d'information à un premier instant de détection $t_{ZCA1,1}$, horodaté localement, d'un nouveau passage à zéro du signal prélevé au niveau du premier dispositif (1) d'acquisition de données ;
    - horodatage local (130) de l'instant de réception dudit signal d'information par le deuxième dispositif d'acquisition de données ;
    - déclenchement (140), par le premier dispositif d'acquisition de données, d'une première phase d'acquisition d'évènements haute fréquence sur une pluralité de cycles successifs de durée de cycle prédéfinie, la première phase d'acquisition étant déclenchée à un premier instant de déclenchement $t_{RA}$ déterminé localement par le premier moyen d'horodatage (13) et séparé du premier instant de détection d'une durée correspondant à la première estimation $T'_A$ de la période du signal électrique ;
    - après écoulement d'une durée correspondant à la moitié de la deuxième estimation $T'_B$ de la période du signal électrique suivant ledit instant de réception, déclenchement (150), par le deuxième dispositif (1) d'acquisition de données, d'une deuxième phase d'acquisition d'évènements haute fréquence sur une pluralité de cycles successifs de durée de cycle prédéfinie, la deuxième phase d'acquisition étant déclenchée à un deuxième instant de déclenchement $t_{RB}$ déterminé localement par le deuxième moyen d'horodatage (13) et correspondant à un deuxième instant de détection d'un nouveau passage à zéro du signal prélevé au niveau du deuxième dispositif (1) d'acquisition de données ; et

- détermination (160) d'une différence de synchronisation $\Delta t_{oa}$ entre un premier évènement haute fréquence et un deuxième évènement haute fréquence acquis, sur un cycle donné, respectivement par le premier dispositif d'acquisition de données (1) à un premier instant d'acquisition horodaté localement par le premier moyen d'horodatage (13) et par le deuxième dispositif d'acquisition de données (1) à un deuxième instant d'acquisition horodaté localement par le deuxième moyen d'horodatage (13) par calcul de la différence entre le deuxième instant de déclenchement $t_{RB}$ et le premier instant de déclenchement $t_{RA}$.

2. Procédé selon la revendication 1, dans lequel la durée de cycle prédéfinie pour chaque cycle de la première phase d'acquisition de données correspond à la première estimation $T'_A$ de la période du signal électrique, et la durée de cycle prédéfinie pour chaque cycle de la deuxième phase d'acquisition de données correspond à la deuxième estimation $T'_B$ de la période du signal électrique.

3. Procédé selon l'une quelconque des revendications précédentes, **caractérisé en ce que** les cycles successifs dans la première phase et la deuxième phase d'acquisition de données sont consécutifs.

4. Procédé selon l'une quelconque des revendications 1 à 2, **caractérisé en ce que** les cycles successifs dans la première phase et la deuxième phase d'acquisition de données sont séparés deux à deux d'une durée d'espacement Ts prédéfinie correspondant à un nombre prédéfini de passages consécutifs par zéro.

5. Procédé selon l'une quelconque des revendications précédentes, **caractérisé en ce que** le premier évènement haute fréquence détecté par le premier dispositif (1) d'acquisition de données et le deuxième évènement haute fréquence détecté par le deuxième dispositif (1) de données sur un cycle donné correspondent à deux signaux générés par une même décharge partielle (2) en un point du réseau situé entre le premier et le deuxième dispositifs (1) d'acquisition de données, et **en ce que** le procédé comporte en outre une étape de calcul de la localisation $Z_{PD}$ de la décharge partielle selon la relation

$$Z_{PD} = \frac{TOF' - \Delta t_{oa}}{2TOF'} . l_C$$

dans laquelle $l_C$ est une longueur de câble entre le premier et le deuxième dispositifs (1) d'acquisition de données.

6. Système de surveillance en ligne d'un réseau de distribution électrique comportant au moins un premier et un deuxième dispositif (1) d'acquisition de données, chaque dispositif (1) d'acquisition de données étant localisé en un point connu du réseau et étant configuré pour détecter des évènements haute fréquence lors de phases d'acquisition de données, le système de surveillance en ligne étant **caractérisé en ce qu'**il comporte :

- un premier moyen d'horodatage local (13) et un premier module de détection de passage par zéro (12), associés au premier dispositif (1) d'acquisition de données, et configurés pour prélever le signal électrique parcourant le réseau au niveau du premier dispositif d'acquisition de données (1) et détecter les instants de passages par zéro du signal prélevé, horodatés localement par le premier moyen d'horodatage (13) ;
- un deuxième moyen d'horodatage local (13) et un deuxième module de détection de passages par zéro (12), associés au deuxième dispositif (1) d'acquisition de données, et configurés pour prélever le signal électrique parcourant le réseau au niveau du deuxième dispositif d'acquisition de données (1) et détecter les instants de passages par zéro du signal prélevé, horodatés localement par le deuxième moyen d'horodatage (15) ; et
- des moyens de synchronisation configurés pour :

lors d'une première phase d'estimations, déduire une première estimation $T'_A$ de la période du signal électrique à partir d'instants de passages par zéro successivement horodatés localement par le premier moyen d'horodatage (13), et une deuxième estimation $T'_B$ de la période du signal électrique à partir d'instants de passages par zéro successivement horodatés localement par le deuxième moyen d'horodatage (13), et pour effectuer une deuxième phase de synchronisation comprenant les étapes suivantes :

- envoi (120) par le premier dispositif d'acquisition de données d'un signal d'information à un premier instant de détection $t_{ZCA1,1}$, horodaté localement, d'un nouveau passage à zéro du signal prélevé au niveau du premier dispositif (1) d'acquisition de données ;

- horodatage local (130) de l'instant de réception dudit signal d'information par le deuxième dispositif d'acquisition de données ;

- déclenchement (140), par le premier dispositif d'acquisition de données, d'une première phase d'acquisition d'évènements haute fréquence sur une pluralité de cycles successifs de durée de cycle prédéfinie, la première phase d'acquisition étant déclenchée à un premier instant de déclenchement $t_{RA}$ déterminé localement par le premier moyen d'horodatage (13) et séparé du premier instant de détection d'une durée correspondant à la première estimation $T'_A$ de la période du signal électrique ;

- après écoulement d'une durée correspondant à la moitié de la deuxième estimation $T'_B$ de la période du signal électrique suivant ledit instant de réception, déclenchement (150), par le deuxième dispositif (1) d'acquisition de données, d'une deuxième phase d'acquisition d'évènements haute fréquence sur une pluralité de cycles successifs de durée de cycle prédéfinie, la deuxième phase d'acquisition étant déclenchée à un deuxième instant de déclenchement $t_{RB}$ déterminé localement par le deuxième moyen d'horodatage (13) et correspondant à un deuxième instant de détection d'un nouveau passage à zéro du signal prélevé au niveau du deuxième dispositif (1) d'acquisition de données ; et

- détermination (160) d'une différence de synchronisation $\Delta t_{oa}$ entre un premier évènement haute fréquence et un deuxième évènement haute fréquence acquis, sur un cycle donné, respectivement par le premier dispositif d'acquisition de données (1) à un premier instant d'acquisition horodaté localement par le premier moyen d'horodatage (13) et par le deuxième dispositif d'acquisition de données (1) à un deuxième instant d'acquisition horodaté localement par le deuxième moyen d'horodatage (13) par calcul de la différence entre le deuxième instant de déclenchement $t_{RB}$ et le premier instant de déclenchement $t_{RA}$.

7. Système selon la revendication 6, **caractérisé en ce que** le premier moyen d'horodatage et le deuxième moyen d'horodatage sont des compteurs N bits, N étant un entier supérieur ou égal à 16.

8. Système selon l'une quelconque des revendications 6 et 7, dans lequel le premier moyen d'horodatage (13) est intégré au premier dispositif (1) d'acquisition des données, et/ou le deuxième moyen d'horodatage est intégré au deuxième dispositif (1) d'acquisition des données.

9. Système selon l'une quelconque des revendications 6 à 8, dans lequel le premier module de détection de passage par zéro (12) est intégré au premier dispositif (1) d'acquisition des données, et/ou le deuxième module de détection de passage par zéro (12) est intégré au deuxième dispositif (1) d'acquisition des données.

## Patentansprüche

1. Verfahren zur Synchronisation zwischen mindestens einem ersten Datenerfassungsgerät (1) und einem zweiten Datenerfassungsgerät (1) eines Online-Überwachungssystems für ein Stromverteilnetz, wobei jedes Datenerfassungsgerät (1) an einem bekannten Punkt des Netzes lokalisiert ist und so konfiguriert ist, dass es Hochfrequenzereignisse während Erfassungsphasen erkennt, wobei das Verfahren umfasst:

eine erste Phase (110) von Schätzungen der Periode des im Netz fließenden elektrischen Signals, bestehend aus:

- das im Netz fließende elektrische Signal am ersten Datenerfassungsgerät (1) entnehmen und daraus eine erste Schätzung $T'_A$ der Periodendauer des elektrischen Signals durch Erkennung der Zeitpunkte von Nulldurchgängen des entnommenen Signals ableiten, lokal mit einem ersten Zeitstempelgerät (13) des ersten Datenerfassungsgeräts (1) zeitgestempelt;

- das im Netz fließende elektrische Signal am zweiten Datenerfassungsgerät (1) entnehmen und daraus eine zweite Schätzung $T'_B$ der Periodendauer des elektrischen Signals durch Erkennung der Zeitpunkte von Nulldurchgängen des entnommenen Signals ableiten, lokal mit einem zweiten Zeitstempelgerät (13) des zweiten Datenerfassungsgeräts (1) zeitgestempelt, gefolgt von einer zweiten Synchronisationsphase, die die folgenden Schritte umfasst:

- Aussenden (120) durch das erste Datenerfassungsgerät (1) eines Informationssignals zu einem ersten Erkennungszeitpunkt $t_{ZCA1,1}$, lokal zeitgestempelt, über einen neuen Nulldurchgang des am ersten Datenerfassungsgerät (1) entnommenen Signals;

- lokale Zeitstempelung (130) des Empfangszeitpunkts des genannten Informationssignals durch das zweite Datenerfassungsgerät;

- Auslösung (140), durch das erste Datenerfassungsgerät (1), einer ersten Erfassungsphase für Hochfrequenzereignisse über eine Vielzahl aufeinanderfolgender Zyklen mit vordefinierter Zyklusdauer, wobei die erste Erfassungsphase zu einem ersten Auslösezeitpunkt $t_{RA}$ lokal durch das erste Zeitstempelgerät (13) bestimmt wird und vom ersten Erkennungszeitpunkt um eine Dauer getrennt ist, die der ersten Schätzung $T'_A$ der Periodendauer des elektrischen Signals;

- nach Ablauf einer Dauer, die der Hälfte der zweiten Schätzung $T'_B$ der Periodendauer des elektrischen Signals nach genanntem Empfangszeitpunkt entspricht, Auslösung (150) durch das zweite Datenerfassungsgerät (1) einer zweiten Erfassungsphase für Hochfrequenzereignisse über eine Vielzahl aufeinanderfolgender Zyklen mit vordefinierter Zyklusdauer, wobei die zweite Erfassungsphase zu einem zweiten Auslösezeitpunkt $t_{RB}$ lokal durch das zweite Zeitstempelgerät (13) bestimmt wird und einem zweiten Erkennungszeitpunkt eines neuen Nulldurchgangs des am zweiten Datenerfassungsgerät (1) entnommenen Signals entspricht; und

- Bestimmung (160) einer Synchronisationsdifferenz $\Delta t_{oa}$ zwischen einem ersten Hochfrequenzereignis und einem zweiten Hochfrequenzereignis, jeweils auf einem gegebenen Zyklus vom ersten Datenerfassungsgerät (1) zu einem ersten Erwerbszeitpunkt, lokal durch das erste Zeitstempelgerät (13) zeitgestempelt, und vom zweiten Datenerfassungsgerät (1) zu einem zweiten Erwerbszeitpunkt, lokal durch das zweite Zeitstempelgerät (13) zeitgestempelt, erfasst, durch Berechnung der Differenz zwischen dem zweiten Auslösezeitpunkt $t_{RB}$ und dem ersten Auslösezeitpunkt $t_{RA}$.

2. Verfahren nach Anspruch 1, wobei die vordefinierte Zyklusdauer für jeden Zyklus der ersten Erfassungsphase der ersten Schätzung $T'_A$ der Periodendauer des elektrischen Signals entspricht, und die vordefinierte Zyklusdauer für jeden Zyklus der zweiten Erfassungsphase der zweiten Schätzung T's der Periodendauer des elektrischen Signals entspricht.

3. Verfahren nach einem der vorstehenden Ansprüche, **dadurch gekennzeichnet, dass** die aufeinanderfolgenden Zyklen in der ersten und der zweiten Datenerfassungsphase aufeinanderfolgend sind.

4. Verfahren nach einem der Ansprüche 1 bis 2, **dadurch gekennzeichnet, dass** die aufeinanderfolgenden Zyklen in der ersten und der zweiten Datenerfassungsphase paarweise durch eine vordefinierte Abstandsdauer Ts getrennt sind, die einer vordefinierten Anzahl aufeinanderfolgender Nulldurchgänge entspricht.

5. Verfahren nach einem der vorstehenden Ansprüche, **dadurch gekennzeichnet, dass** das erste vom ersten Datenerfassungsgerät (1) erkannte Hochfrequenzereignis und das zweite vom zweiten Datenerfassungsgerät (1) erkannte Hochfrequenzereignis in einem gegebenen Zyklus zwei Signale sind, die durch dieselbe Teilentladung (2) an einem Punkt des Netzes erzeugt werden, der zwischen dem ersten und dem zweiten Datenerfassungsgerät (1) liegt, und dass das Verfahren ferner einen Schritt zur Berechnung der Lokalisation $Z_{PD}$ der Teilentladung gemäß der Beziehung aufweist

$$Z_{PD} = \frac{TOF' - \Delta t_{oa}}{2TOF'} \cdot l_c$$

wobei $l_c$ eine Kabellänge zwischen dem ersten und dem zweiten Datenerfassungsgerät (1) ist.

6. Online-Überwachungssystem eines Stromverteilnetzes, das mindestens ein erstes und ein zweites Datenerfassungsgerät (1) aufweist, wobei jedes Datenerfassungsgerät (1) an einem bekannten Punkt des Netzes lokalisiert ist und so konfiguriert ist, dass es während Datenerfassungsphasen Hochfrequenzereignisse erkennt, wobei das Online-Überwachungssystem **dadurch gekennzeichnet ist, dass** es aufweist:

- ein erstes lokales Zeitstempelgerät (13) und ein erstes Modul zur Erkennung von Nulldurchgängen (12), zugeordnet zu dem ersten Datenerfassungsgerät (1) und so konfiguriert, dass sie das im Netz fließende elektrische Signal am Standort des ersten Datenerfassungsgeräts (1) abnehmen und die Zeitpunkte von Nulldurchgängen des abgenommenen Signals erkennen, die lokal vom ersten Zeitstempelgerät (13) zeitgestempelt werden;

- ein zweites lokales Zeitstempelgerät (13) und ein zweites Modul zur Erkennung von Nulldurchgängen (12), zugeordnet zu dem zweiten Datenerfassungsgerät (1) und so konfiguriert, dass sie das im Netz fließende elektrische Signal am Standort des zweiten Datenerfassungsgeräts (1) abnehmen und die Zeitpunkte von Nulldurchgängen des abgenommenen Signals erkennen, die lokal vom zweiten Zeitstempelgerät (15) zeitgestempelt werden; und

- Synchronisationsmittel, konfiguriert, um:

während einer ersten Schätzphase eine erste Schätzung T'$_A$ der Periode des elektrischen Signals aus Zeitpunkten von Nulldurchgängen ableiten, die nacheinander lokal vom ersten Zeitstempelgerät (13) zeitgestempelt wurden, und eine zweite Schätzung T'$_B$ der Periode des elektrischen Signals aus Zeitpunkten von Nulldurchgängen ableiten, die nacheinander lokal vom zweiten Zeitstempelgerät (13) zeitgestempelt wurden,
und um eine zweite Synchronisationsphase durchzuführen, die die folgenden Schritte umfasst:

- Übermittlung (120) durch das erste Datenerfassungsgerät eines Informationssignals an einen ersten Erkennungszeitpunkt t$_{zCA1,1}$, lokal zeitgestempelt, eines neuen Nulldurchgangs des am ersten Datenerfassungsgerät (1) entnommenen Signals;
- lokale Zeitstempelung (130) des Empfangszeitpunkts des genannten Informationssignals durch das zweite Datenerfassungsgerät;
- Auslösung (140) durch das erste Datenerfassungsgerät einer ersten Erfassungsphase für Hochfrequenzereignisse über eine Vielzahl aufeinanderfolgender Zyklen mit vordefinierter Zyklusdauer, wobei die erste Erfassungsphase zu einem ersten Auslösezeitpunkt t$_{RA}$ lokal durch das erste Zeitstempelgerät (13) bestimmt wird und vom ersten Erkennungszeitpunkt um eine Dauer getrennt ist, die der ersten Schätzung T'$_A$ der Periode des elektrischen Signals entspricht;
- nach Ablauf einer Dauer, die der Hälfte der zweiten Schätzung T'$_B$ der Periode des elektrischen Signals nach dem genannten Empfangszeitpunkt entspricht, Auslösung (150) durch das zweite Datenerfassungsgerät (1) einer zweiten Erfassungsphase für Hochfrequenzereignisse über eine Vielzahl aufeinanderfolgender Zyklen mit vordefinierter Zyklusdauer, wobei die zweite Erfassungsphase zu einem zweiten Auslösezeitpunkt t$_{RB}$ lokal durch das zweite Zeitstempelgerät (13) bestimmt wird und einem zweiten Erkennungszeitpunkt eines neuen Nulldurchgangs des am zweiten Datenerfassungsgerät (1) entnommenen Signals entspricht; und
- Bestimmung (160) einer Synchronisationsdifferenz $\Delta t_{oa}$ zwischen einem ersten Hochfrequenzereignis und einem zweiten Hochfrequenzereignis, die auf einem gegebenen Zyklus jeweils vom ersten Datenerfassungsgerät (1) zu einem ersten, lokal vom ersten Zeitstempelgerät (13) zeitgestempelten Erfassungszeitpunkt bzw. vom zweiten Datenerfassungsgerät (1) zu einem zweiten, lokal vom zweiten Zeitstempelgerät (13) zeitgestempelten Erfassungszeitpunkt erfasst wurden, durch Berechnung der Differenz zwischen dem zweiten Auslösezeitpunkt t$_{RB}$ und dem ersten Auslösezeitpunkt t$_{RA}$.

7. System nach Anspruch 6, **dadurch gekennzeichnet, dass** das erste Zeitstempelgerät und das zweite Zeitstempelgerät N-Bit-Zähler sind, wobei N eine ganze Zahl größer oder gleich 16 ist.

8. System nach einem der Ansprüche 6 und 7, wobei das erste Zeitstempelgerät (13) in das erste Datenerfassungsgerät (1) integriert ist und/oder das zweite Zeitstempelgerät in das zweite Datenerfassungsgerät (1) integriert ist.

9. System nach einem der Ansprüche 6 bis 8, wobei das erste Modul zur Erkennung von Nulldurchgängen (12) in das erste Datenerfassungsgerät (1) integriert ist und/oder das zweite Modul zur Erkennung von Nulldurchgängen (12) in das zweite Datenerfassungsgerät (1) integriert ist.

## Claims

1. A method for synchronization between at least a first data acquisition device (1) and a second data acquisition device (1) of an online monitoring system for monitoring an electrical distribution network, each data acquisition device (1) being located at a known point in the network and being configured to detect high-frequency events during data acquisition phases, the method comprising:

a first phase (110) of estimating the period of the electrical signal travelling through the network, including:

- sampling the electrical signal travelling through the network at the first data acquisition device (1) and deducing therefrom a first estimate T'$_A$ of the period of the electrical signal by detecting times of zero crossings of the sampled signal, which are locally timestamped by a first timestamping means (13) associated with the first data acquisition device (1);
- sampling the electrical signal travelling through the network at the second data acquisition device (1) and deducing therefrom a second estimate T'$_B$ of the period of the electrical signal by detecting times of zero crossings of the sampled signal, which are locally timestamped by a second timestamping means (13) associated with the second data acquisition device (1);

followed by a second synchronization phase, including the following steps:

- the first data acquisition device (1) sending (120) an information signal at a first time of detection $t_{ZCA1,1}$, which is locally timestamped, of a new zero crossing of the signal sampled at the first data acquisition device;
- the second data acquisition device (1) locally timestamping (130) the time of reception of said information signal;
- the first data acquisition device (1) triggering (140) a first phase of acquiring high-frequency events over a plurality of successive cycles having a predefined cycle duration, the first acquisition phase being triggered at a first triggering time $t_{RA}$ determined locally by the first timestamping means (13) and separated from the first time of detection by a duration corresponding to the first estimate $T'_A$ of the period of the electrical signal;
- after a duration corresponding to half the second estimate $T'_B$ of the period of the electrical signal following said time of reception has elapsed, the second data acquisition device (1) triggering (150) a second phase of acquiring high-frequency events over a plurality of successive cycles having a predefined cycle duration, the second acquisition phase being triggered at a second triggering time $t_{RB}$ determined locally by the second timestamping means (13) and corresponding to a second time of detection of a new zero crossing of the signal sampled at the second data acquisition device (1); and
- determining (160) a synchronization difference $\Delta t_{oa}$ between a first high-frequency event and a second high-frequency event acquired, over a given cycle, respectively by the first data acquisition device (1) at a first acquisition time locally timestamped by the first timestamping means (13) and by the second data acquisition device (1) at a second acquisition time locally timestamped by the second timestamping means (13) by calculating the difference between the second triggering time $t_{RB}$ and the first triggering time $t_{RA}$.

2. The method according to claim 1, wherein the predefined cycle duration for each cycle of the first data acquisition phase corresponds to the first estimate $T'_A$ of the period of the electrical signal, and the predefined cycle duration for each cycle of the second data acquisition phase corresponds to the second estimate $T'_B$ of the period of the electrical signal.

3. The method according to any one of the preceding claims, wherein the successive cycles in the first and second data acquisition phase are consecutive.

4. The method according to any one of claims 1 to 2, wherein the successive cycles in the first and second data acquisition phase are separated in pairs by a predefined spacing duration $T_S$ corresponding to a predefined number of consecutive zero crossings.

5. The method according to any one of the preceding claims, wherein the first high-frequency event detected by the first data acquisition device (1) and the second high-frequency event detected by the second data acquisition device (1) over a given cycle correspond to two signals generated by the same partial discharge (2) at a point of the network located between the first and second data acquisition devices (1), and in that the method furthermore comprises a step of calculating the location $Z_{PD}$ of the partial discharge using the relationship

$$Z_{PD} = \frac{TOF' - \Delta t_{oa}}{2TOF'} . l_C$$

in which $l_C$ is a length of cable between the first and second data acquisition devices (1).

6. An online monitoring system for monitoring an electrical distribution network having at least a first data acquisition device (1) and a second data acquisition device (1), each data acquisition device (1) being located at a known point in the network and being configured to detect high-frequency events during data acquisition phases, the online monitoring system comprising:

- a first local timestamping means (13) and a first zero crossing detection module (12), which are associated with the first data acquisition device (1), and configured to sample the electrical signal travelling through the network at the first data acquisition device (1) and detect the times of zero crossings of the sampled signal, which are locally timestamped by the first timestamping means (13);
- a second local timestamping means (13) and a second zero crossing detection module (12), which are associated with the second data acquisition device (1), and configured to sample the electrical signal travelling through the network at the second data acquisition device (1) and detect the times of zero crossings of the sampled signal, which are locally timestamped by the second timestamping means (13); and
- synchronization means configured:

in a first estimation phase, to deduce a first estimate $T'_A$ of the period of the electrical signal from times of zero crossings that are successively locally timestamped by the first timestamping means (13), and a second estimate $T'_B$ of the period of the electrical signal from times of zero crossings that are successively locally timestamped by the second timestamping means (13),
and to perform a second synchronization phase, comprising the following steps:

- the first data acquisition device sending (120) an information signal at a first time of detection $t_{ZCA1,1}$, which is locally timestamped, of a new zero crossing of the signal sampled at the first data acquisition device (1);
- the second data acquisition device (1) locally timestamping (13) the time of reception of said information signal;
- the first data acquisition device triggering (140) a first phase of acquiring high-frequency events over a plurality of successive cycles having a predefined cycle duration, the first acquisition phase being triggered at a first triggering time $t_{RA}$ determined locally by the first timestamping means (13) and separated from the first time of detection by a duration corresponding to the first estimate $T'_A$ of the period of the electrical signal;
- after a duration corresponding to half the second estimate $T'_B$ of the period of the electrical signal following said time of reception has elapsed, the second data acquisition device triggering (150) a second phase of acquiring high-frequency events over a plurality of successive cycles having a predefined cycle duration, the second acquisition phase being triggered at a second triggering time $t_{RB}$ determined locally by the second timestamping means (13) and corresponding to a second time of detection of a new zero crossing of the signal sampled at the second data acquisition device (1); and
- determining (160) a synchronization difference $\Delta t_{oa}$ between a first high-frequency event and a second high-frequency event acquired, over a given cycle, respectively by the first data acquisition device (1) at a first acquisition time locally timestamped by the first timestamping means (13) and by the second data acquisition device (1) at a second acquisition time locally timestamped by the second timestamping means (13) by calculating the difference between the second triggering time $t_{RB}$ and the first triggering time $t_{RA}$.

7. The system according to claim 6, wherein the first timestamping means and the second timestamping means are N-bit counters, N being an integer greater than or equal to 16.

8. The system according to any one of claims 6 and 7, wherein the first timestamping means (13) is integrated into the first data acquisition device, and/or the second timestamping means is integrated into the second data acquisition device (1).

9. The system according to any one of claims 6 to 8, wherein the first zero crossing detection module (12) is integrated into the first data acquisition device (1), and/or the second zero crossing detection module (12) is integrated into the second data acquisition device (1).

FIG.1 (art antérieur)

FIG.2

**FIG.3**

**FIG.4**

**FIG.5**

$$t_{RA} = t_{ZCA1,1} + T'_A$$

$$t_{RB} = t_{ZCB1,1}$$

**FIG.6**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2021138569 A
- WO 2004013642 A2